# EUROPEAN PATENT SPECIFICATION

(11) **EP 4 120 814 B1**
(45) Date of publication and mention of the grant of the patent: **30.10.2024**
(21) Application number: 20924283.3
(22) Date of filing: 11.03.2020
(51) Int. Cl.: H05K 13/08

(54) **SUBSTRATE HEIGHT MEASURING DEVICE AND SUBSTRATE HEIGHT MEASURING METHOD**
VORRICHTUNG UND VERFAHREN ZUR MESSUNG DER HÖHE EINES SUBSTRATS
DISPOSITIF DE MESURE DE HAUTEUR DE SUBSTRAT ET PROCÉDÉ DE MESURE DE HAUTEUR DE SUBSTRAT

(43) Date of publication of application: 18.01.2023
(73) Proprietor: Fuji Corporation, Chiryu-shi, Aichi 472-8686 (JP)
(72) Inventor: YAMAZAKI, Tomohiro, Chiryu-shi, Aichi 472-8686 (JP)
(74) Representative: Grünecker Patent- und Rechtsanwälte PartG mbB
(86) International application number: PCT/JP2020/010489
(87) International publication number: WO 2021/181556

(56) References cited:
- WO-A1-2007/063763
- WO-A1-2018/216132
- WO-A1-2018/216132
- JP-A- 2008 277 451
- JP-A- 2009 027 015
- JP-A- 2011 233 738
- JP-A- 2011 233 738
- JP-A- 2018 200 937

## Description

### Technical Field

The present specification discloses techniques related to a substrate height measuring device and a substrate height measuring method.

### Background Art

Patent Literature 1 discloses a method of acquiring substrate height data by excluding abnormality data from measurement data in substrate height measurement such as during teaching operation. Specifically, since a substrate formed of an epoxy or the like is a rigid body, a surface of the substrate is flat when viewed from the extreme point of view. Therefore, a measurement value of the height of the substrate measured by slightly scanning changes a little, but no abrupt change occurs. Therefore, the above-described method described in Patent Literature 1 acquires measurement data at predetermined intervals in a predetermined region while moving a substrate height measurement sensor at a constant speed, and excludes the measurement data as an abnormal value when the measurement data is not included in a predetermined range indicating normal data.

WO 2018/216132 A1 relates to a measurement position determination device. In particular, a preset temporary measurement position is acquired. Based on the acquired temporary measurement position and on a planned mounting position, a measurement position of the substrate height is determined. The substrate height is measured at the determined measurement position.

JP 2011 233738 relates to measurement of the height level of a substrate. In particular, components graphics and measuring point graphics are displayed: Based on the display, an operator can delete or correct measurement positions.

### Patent Literature

Patent Literature 1: JP-A-2009-27015

### Summary of the Invention

### Technical Problem

For example, a circuit forming member such as a wiring pattern, a through hole, and a component is provided on a substrate. In addition, an identification code or the like for identifying a substrate product is attached to the substrate. These members may affect a measurement device when measuring a height of the substrate, thereby reducing measurement accuracy.

In view of such a circumstance, the present specification discloses a substrate height measuring device and a substrate height measuring method capable of adjusting a measurement position at which a measurement device actually measures a height of a substrate and measuring the height of the substrate.

### Solution to Problem

The scope of the invention is defined in the independent claims.

*[empty]*

### Advantageous Effect of the Invention

According to the substrate height measuring device described above, the imaging section, the setting section, and the measurement section are provided. Therefore, the substrate height measuring device can adjust the measurement position at which the height of the substrate is actually measured based on the measurement planned position of the substrate image displayed on the display device, and thus, can allow the measurement device to measure the height of the substrate. The above description of the substrate height measuring device can be similarly applied to the substrate height measuring method.

### Brief Description of Drawings

[Fig. 1] Fig. 1 is a plan view illustrating a configuration example of a component mounter.
[Fig. 2] Fig. 2 is a block diagram illustrating an example of a control block of a substrate height measuring device.
[Fig. 3] Fig. 3 is a flowchart illustrating an example of a control procedure by the substrate height measuring device.
[Fig. 4] Fig. 4 is a schematic diagram illustrating an example of a member provided on a substrate.
[Fig. 5] Fig. 5 is a plan view of a substrate illustrating a setting example of a measurement planned position.
[Fig. 6] Fig. 6 is a schematic diagram illustrating an example of a substrate image displayed on a display device.
[Fig. 7] Fig. 7 is a schematic diagram illustrating another example of a substrate image displayed on the display device.
[Fig. 8] Fig. 8 is a schematic diagram illustrating a setting example of a reference measurement position and a related measurement position.
[Fig. 9] Fig. 9 is a schematic diagram illustrating a display example of a measurement result of the height of the substrate measured at the measurement position in Fig. 8.

### Description of Embodiments

### 1. Embodiment

### 1-1. Configuration example of component mounter 10

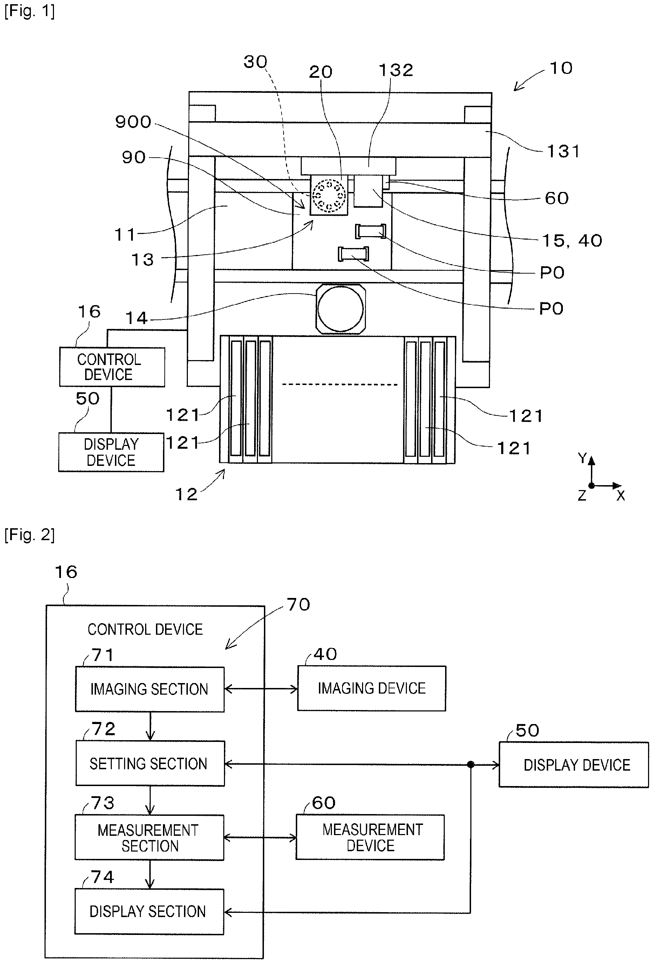

Substrate height measuring device 70 may be provided in a substrate working machine that needs to measure a height of clamped substrate 90. For example, a printer, a printing inspection machine, component mounter 10, and an appearance inspector are included in the substrate working machine. Substrate height measuring device 70 of the present embodiment is provided in component mounter 10. Component mounter 10 mounts multiple components P0 on substrate 90. As illustrated in Fig. 1, component mounter 10 includes substrate conveyance device 11, component supply device 12, component transfer device 13, part camera 14, substrate camera 15, and control device 16.

For example, substrate conveyance device 11 includes a belt conveyor or the like, and conveys substrate 90 in a conveyance direction (X-axis direction). Substrate 90 is a circuit substrate on which an electronic circuit, an electrical circuit, a magnetic circuit, and the like are formed. Substrate conveyance device 11 conveys substrate 90 into component mounter 10, and positions and clamps substrate 90 at a predetermined position in component mounter 10. After mounting process of multiple components P0 by component mounter 10 is completed, substrate conveyance device 11 unclamps substrate 90 and conveys substrate 90 to the outside of component mounter 10.

Component supply device 12 supplies multiple components P0 to be mounted on substrate 90. Component supply device 12 includes multiple feeders 121 that are provided along the conveyance direction (X-axis direction) of substrate 90. Each of multiple feeders 121 pitch-feeds a carrier tape in which multiple components P0 are housed, so as to collectably supply components P0 at a supply position located on a distal end side of feeder 121. Moreover, component supply device 12 can supply a relatively large electronic component (lead component or the like) as compared with a chip component or the like in a state of being disposed on a tray.

Component transfer device 13 includes head driving device 131 and moving body 132. Head driving device 131 is configured to move moving body 132 in the X-axis direction and the Y-axis direction by a linear motion mechanism. Mounting head 20 is detachably (exchangeably) provided on moving body 132 by a clamp member. Mounting head 20 uses at least one holding member 30 to collect and hold component P0 supplied by component supplying device 12, and mounts component P0 on substrate 90 positioned by substrate conveyance device 11. For example, holding member 30 can use a suction nozzle, a chuck, and the like.

As part camera 14 and substrate camera 15, a well-known imaging device can be used. Part camera 14 is fixed to a base of component mounter 10 such that an optical axis faces upward in a vertical direction (Z-axis direction). Part camera 14 can image an image of component P0 held by holding member 30 from below. Substrate camera 15 is provided on moving body 132 of component transfer device 13 such that the optical axis faces downward in the vertical direction (Z-axis direction). Substrate camera 15 can image substrate 90 from above. Part camera 14 and substrate camera 15 perform imaging based on a control signal transmitted from control device 16. Image data of the captured image imaged by part camera 14 and substrate camera 15 is transmitted to control device 16.

Control device 16 includes a known arithmetic device and a storage device, and constitutes a control circuit. Information, image data, and the like output from various sensors provided in component mounter 10 are input to control device 16. Control device 16 transmits the control signals to each device based on a control program, a predetermined mounting condition which is set in advance, and the like.

For example, control device 16 allows substrate camera 15 to image substrate 90 which is positioned by substrate conveyance device 11. Control device 16 performs image processing of the captured image imaged by substrate camera 15 to recognize a positioning state of substrate 90. In addition, control device 16 allows holding member 30 to collect and hold component P0 supplied by component supplying device 12, and part camera 14 to image component P0 held by holding member 30. Control device 16 performs image processing on the captured image imaged by part camera 14 to recognize a holding posture of component P0.

Control device 16 moves holding member 30 upwards a mounting planned position set in advance by a control program or the like. In addition, control device 16 corrects the mounting planned position based on the positioning state of substrate 90, the holding posture of component P0, and the like, and sets the mounting position at which component P0 is actually mounted. The mounting planned position and the mounting position include a rotation angle in addition to the position (an X-axis coordinate and a Y-axis coordinate).

Control device 16 corrects a target position (the X-axis coordinate and the Y-axis coordinate) of holding member 30 and the rotation angle according to the mounting position. Control device 16 lowers holding member 30 at the corrected rotation angle at the corrected target position, and mounts component P0 on substrate 90. Control device 16 executes the mounting process for mounting multiple components P0 on substrate 90 by repeating the pick-and-place cycle described above.

### 1-2. Configuration example of substrate height measuring device 70

### 1-2-1. Outline of substrate height measuring device 70

Substrate height measuring device 70 of the present embodiment is provided in control device 16 of component mounter 10. When viewed as a control block, substrate height measuring device 70 includes imaging section 71, setting section 72, and measurement section 73. Substrate height measuring device 70 may also include display section 74. As illustrated in Fig. 2, substrate height measuring device 70 of the present embodiment includes imaging section 71, setting section 72, measurement section 73, and display section 74.

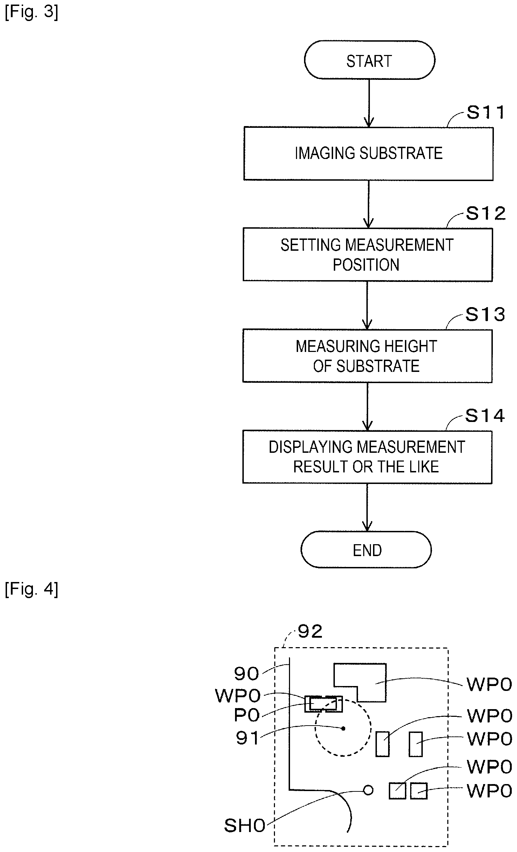

In addition, substrate height measuring device 70 of the present embodiment executes control according to a flowchart illustrated in Fig. 3. Imaging section 71 performs processing illustrated in Step S11. Setting section 72 performs processing illustrated in Step S12. Measurement section 73 performs processing illustrated in Step S13. Display section 74 performs processing illustrated in Step S14.

Fig. 4 illustrates an example of a member provided on the substrate. Fig. 4 is an enlarged plan view of a portion of substrate 90 clamped by substrate conveyance device 11. As illustrated in the drawing, for example, circuit forming members such as wiring pattern WP0, through hole SH0, and component P0 are provided on substrate 90. In addition, an identification code or the like for identifying substrate product 900 is attached to substrate 90. These members may affect measurement device 60 when measurement device 60 measures the height of substrate 90, thereby reducing measurement accuracy.

For example, it is assumed that measurement device 60 for measuring the height of substrate 90 is an optical measurement device. In this case, measurement device 60 projects laser light on substrate 90, receives the laser light reflected by substrate 90, and measures the height of substrate 90 by the principle of triangulation. Therefore, in a case where the member is provided in the vicinity of measurement planned position 91 where the height of substrate 90 is to be measured, there is a possibility that the laser light is scattered by the member, and thus, the measurement accuracy is reduced. In Fig. 4, a region that may affect the measurement accuracy is indicated by a dashed-line circle. In the drawing, a part of component P0 and wiring pattern WP0 is included in a circle, and the drawing indicates that the measurement accuracy of measurement device 60 may be reduced.

Substrate height measuring device 70 allows display device 50 to display substrate image 90M imaged by imaging section 71. Then, substrate height measuring device 70 allows measurement device 60 to adjust measurement position 93 at which the height of substrate 90 is actually measured based on measurement planned position 91 of substrate image 90M displayed on display device 50, so that the height of substrate 90 is measured by measurement device 60. Therefore, when a member for reducing the measurement accuracy is provided in the vicinity of measurement planned position 91, it is possible to set measurement position 93 at a position where the member is avoided.

### 1-2-2. Imaging section 71

Imaging section 71 allows imaging device 40 to image region 92 of at least a part of substrate 90, and region 92 includes measurement planned position 91 at which the height of clamped substrate 90 is to be measured (Step S11 illustrated in Fig. 3).

Component mounter 10 confirms a state of warpage of substrate 90 based on the measurement result of the height of substrate 90 measured by substrate height measuring device 70. In addition, component mounter 10 can adjust the height of holding member 30 when component P0 is mounted on substrate 90 based on the measurement result. Therefore, measurement planned position 91 is set so as to be able to confirm the state of warpage of substrate 90 and to adjust the height of holding member 30. Measurement planned position 91 is set in advance in accordance with a substrate type by a control program or the like. For example, the larger a size of substrate 90, the greater the set number of measurement planned positions 91. In addition, the lower rigidity of substrate 90, the greater the set number of measurement planned positions 91. Further, identification information capable of identifying measurement planned position 91 is assigned to multiple measurement planned positions 91.

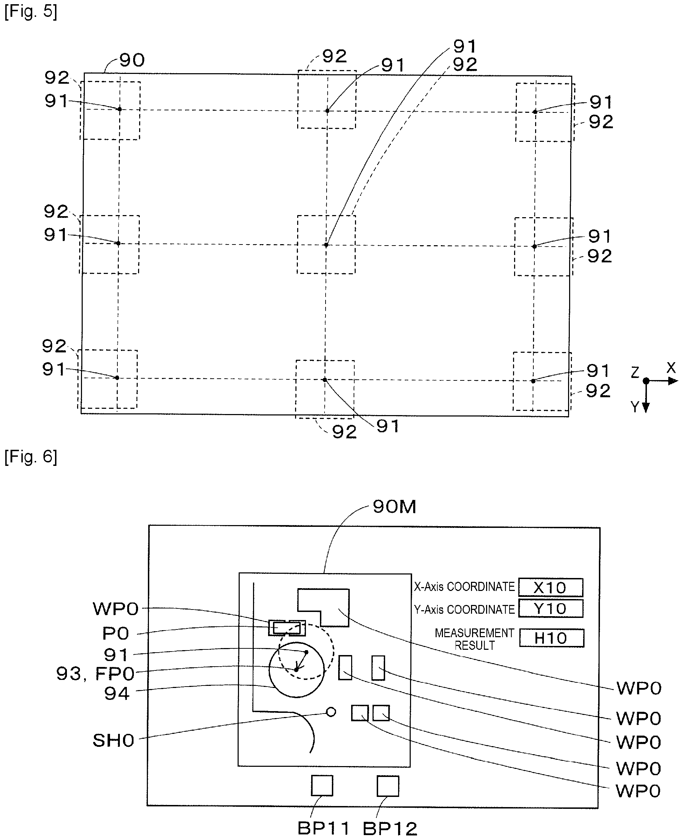

Fig. 5 illustrates a setting example of measurement planned position 91. In the drawing, one measurement planned position 91 is set at the center of substrate 90. In addition, in the drawing, eight measurement planned positions 91 are set along an outer edge portion of substrate 90. By setting at least one measurement planned position 91 at the center portion of substrate 90 and setting multiple measurement planned positions 91 at the outer edge portion of substrate 90, component mounter 10 can easily grasp the state of warpage (concave state or convex state) of substrate 90.

In addition, by setting at least three measurement planned positions 91 in one side direction (X-axis direction) of substrate 90, component mounter 10 can easily grasp the state of warpage (concave state or convex state) of substrate 90 in one side direction (X-axis direction) of substrate 90. By setting at least three measurement planned positions 91 in another side direction (Y-axis direction) of substrate 90, component mounter 10 can easily grasp the state of warpage (concave state or convex state) of substrate 90 in another side direction (Y-axis direction) of substrate 90. By recognizing the state of warpage (concave state or convex state) of substrate 90 in this manner, component mounter 10 can easily adjust the height of holding member 30.

Imaging device 40 can use a known imaging device as long as it can image region 92 of at least a part of substrate 90, the region 92 including measurement planned position 91. As illustrated in Fig. 1, substrate camera 15 is used in imaging device 40 of the present embodiment. As illustrated in Fig. 5, substrate camera 15 can image region 92 of a part of substrate 90 including measurement planned position 91. It should be noted that component mounter 10 may also include an imaging device capable of imaging entire region 92 of substrate 90. In this case, imaging device 40 can also image entire region 92 of substrate 90 including measurement planned position 91.

### 1-2-3. Setting section 72

Setting section 72 allows display device 50 to display substrate image 90M imaged by imaging section 71 and can adjust measurement position 93 at which the height of substrate 90 is actually measured based on measurement planned position 91 of substrate image 90M displayed on display device 50 to set measurement position 93 (Step S12 illustrated in Fig. 3).

Display device 50 can use any well-known display device as long as it can display substrate image 90M captured by imaging section 71. As illustrated in Fig. 1, display device 50 according to the present embodiment uses a display device provided in component mounter 10. Display device 50 may be provided separately.

Fig. 6 illustrates an example of substrate image 90M displayed on display device 50. In substrate image 90M in Fig. 6, region 92 of substrate 90 illustrated in Fig. 4 is imaged. In substrate image 90M, image feature amounts such as brightness and lightness of a region in which a circuit forming member such as wiring pattern WP0, through hole SH0, and component P0 is imaged are different from those of a region in which the circuit forming member is not imaged. Accordingly, in an example not covered by the claims, setting section 72 can adjust measurement position 93 based on the image feature amount of substrate image 90M by performing the image processing on substrate image 90M.

Specifically, since an image feature amount of a region of a part of a dashed-line circle illustrated in Fig. 6 differs from an image feature amount of a region in which the circuit forming member is not imaged, setting section 72 determines that adjustment of measurement position 93 is necessary. Setting section 72 moves measurement position 93 so that the image feature amount of the entire region of the circle is equal to the image feature amount of the region in which the circuit forming member is not imaged. The above description of the circuit forming member also applies to an identification code or the like for identifying substrate product 900.

However, in the above method, for example, the image feature amount may be changed due to imaging conditions of imaging device 40, disturbance during the imaging, or the like, and thus, the adjustment of measurement position 93 may be difficult. Accordingly, setting section 72 can set specific position FP0 of substrate image 90M indicated by an operator as measurement position 93. In this mode, the operator can adjust measurement position 93 while confirming substrate image 90M displayed on display device 50.

The mode in which the operator indicates specific position FP0 is not limited, and may take various forms. For example, setting section 72 can display coordinate axes (X-axis and Y-axis) on substrate image 90M displayed on display device 50, and thus, an operator can input coordinates (X-axis coordinates and Y-axis coordinates) of specific position FP0. In this case, setting section 72 may display grid-shaped auxiliary lines or the like in substrate image 90M displayed on display device 50. As a result, it is easy for the operator to acquire the coordinates of specific position FP0.

Setting section 72 can display indicating member 94 in a predetermined region including measurement planned position 91 of substrate image 90M displayed on display device 50, allow the operator to move indicating member 94 using the input device, and allow the operator to indicate specific position FP0. As a result, the operator can easily indicate specific position FP0.

Indicating member 94 is an assisting means for the operator to indicate specific position FP0, and may take various forms. Indicating member 94 illustrated in Fig. 6 is a circular icon, and the center of the circle corresponds to specific position FP0. Display device 50 of the present embodiment includes a touch panel and also serves as an input device for receiving various operations by an operator. The operator can move indicating member 94 by touching indicating member 94 displayed on display device 50 to indicate specific position FP0. In addition, the operator can use various input devices (for example, a mouse, a keyboard, or the like) provided in component mounter 10 to move indicating member 94 displayed on display device 50 to indicate specific position FP0.

For example, a shape of indicating member 94 can be set to coincide with a range that may affect the measurement accuracy of measurement device 60. As a result, the operator can indicate specific position FP0 so that the circuit forming member or the like is not included in the range that may affect the measurement accuracy of measurement device 60.

For example, in a case where the circuit forming member or the like is not included in the range that may affect the measurement accuracy of measurement device 60, measurement position 93 need not be moved. In this case, measurement position 93 is set to the same position as measurement planned position 91 without being adjusted with respect to measurement planned position 91. In this manner, making measurement position 93 adjustable includes a case where measurement position 93 is set to be adjusted with respect to measurement planned position 91 and a case where measurement position 93 is set at the same position as measurement planned position 91 without being adjusted with respect to measurement planned position 91.

### 1-2-4. Measurement section 73

Measurement section 73 allows measurement device 60 to measure the height of substrate 90 at measurement position 93 set by setting section 72 (Step S13 illustrated in Fig. 3).

Measurement device 60 can use any well-known measurement device as long as it can measure the height of substrate 90. As measurement device 60, for example, various measurement devices such as the optical measurement device and the capacitance measurement device described above can be used. Measurement device 60 of the present embodiment is an optical measurement device. As illustrated in Fig. 1, measurement device 60 of the present embodiment is provided on moving body 132 of component transfer device 13 on which substrate camera 15 is provided.

Measurement section 73 can allow measurement device 60 to measure the height of substrate 90 in trial manufacturing of substrate product 900 performed before manufacturing substrate product 900 on which component P0 is mounted on substrate 90, or in initial product confirmation when the type of substrate product 900 to be manufactured is switched. As a result, the operator or the device (for example, component mounter 10) can confirm a state of warpage of substrate 90 before manufacturing substrate product 900, and can also adjust the height of holding member 30 when component P0 is mounted on substrate 90.

In addition, measurement section 73 can allow measurement device 60 to measure the height of substrate 90 during the manufacturing of substrate product 900. As a result, the operator or the device (for example, component mounter 10) can confirm the state of warpage of substrate 90 during the manufacturing of substrate product 900, and can also adjust the height of holding member 30. In addition, as described later, in the trial manufacturing or the initial product confirmation of substrate product 900 and the manufacturing of substrate product 900, the number of measurements for measuring the height of substrate 90 may be changed for the same type of substrate 90.

### 1-2-5. Display section 74

Display section 74 allows display device 50 to display the coordinates of measurement position 93 on substrate 90 and the measurement result measured by measurement section 73 (Step S14 illustrated in Fig. 3).

Display section 74 may be any section as long as it can display at least the above-mentioned contents on display device 50, and the display method can take various forms. For example, after the height of substrate 90 is measured by measurement device 60, the operator operates operation section BP11 illustrated in Fig. 6. As a result, display section 74 allows display device 50 to display the coordinates (the X-axis coordinate and the Y-axis coordinate) of measurement position 93 on substrate 90 and the measurement result measured by measurement section 73 together with substrate image 90M. Fig. 6 illustrates that the measurement result of the height of substrate 90 at measurement position 93 of X-axis coordinate X10 and Y-axis coordinate Y10 is height H10.

In addition, display section 74 can allow display device 50 to display not only text but also a substrate image or the like indicating the state of warpage of substrate 90. In addition, display section 74 can display the coordinates (X-axis coordinates and Y-axis coordinates) of measurement position 93 on substrate 90 when measurement position 93 is adjusted. In this case, display section 74 can display the coordinates (the X-axis coordinate and the Y-axis coordinate) of measurement position 93 on substrate 90 in accordance with the movement of measurement position 93.

### 1-2-6. Modification example

It may be difficult to grasp a situation around measurement position 93 based on substrate image 90M. For example, unevenness or the like of substrate 90 that is difficult to find based on substrate image 90M may exist around measurement position 93. When measurement device 60 measures height of substrate 90 in such a region, the measurement accuracy may be reduced.

Accordingly, setting section 72 can set related measurement position 93b which is at least one measurement position 93 around reference measurement position 93a that is measurement position 93 adjusted and set with respect to measurement planned position 91, or measurement position 93 set without being adjusted with respect to measurement planned position 91. As a result, the operator or the device (for example, component mounter 10) can grasp the situation in the vicinity of reference measurement position 93a, and can move measurement position 93 as required.

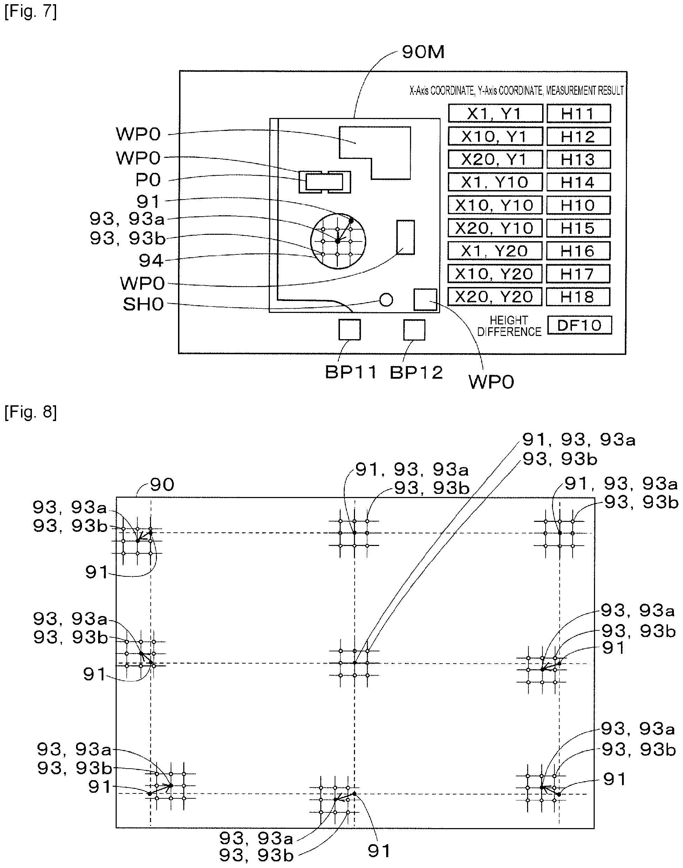

Fig. 7 illustrates another example of substrate image 90M displayed on display device 50. Fig. 7 illustrates that eight related measurement positions 93b are set around reference measurement position 93a of X-axis coordinate X10 and Y-axis coordinate Y10. Measurement planned position 91 and reference measurement position 93a are indicated by black circles, and eight related measurement positions 93b are indicated by white circles. As illustrated in Fig. 7, reference measurement position 93a of X-axis coordinate X10 and Y-axis coordinate Y10 is measurement position 93 adjusted and set with respect to measurement planned position 91.

As described above, measurement position 93 may be set at the same position as measurement planned position 91 without being adjusted with respect to measurement planned position 91. Also in this case, setting section 72 can set at least one related measurement position 93b around reference measurement position 93a.

In addition, disposition of reference measurement position 93a and related measurement position 93b is not limited, but reference measurement position 93a and related measurement position 93b may be disposed on lattice points. As a result, it is easy to uniformly dispose related measurement positions 93b. In the example illustrated in Fig. 7, reference measurement position 93a and eight related measurement positions 93b are disposed on lattice points.

Also in this mode, display section 74 can allow display device 50 to display the coordinates of measurement position 93 on substrate 90 and the measurement result measured by measurement section 73. For example, after the height of substrate 90 is measured by measurement device 60, the operator operates operation section BP11 illustrated in Fig. 7. As a result, display section 74 allows display device 50 to display the coordinates (the X-axis coordinate and the Y-axis coordinate) of substrate 90 and the measurement result measured by measurement section 73 for reference measurement position 93a and eight related measurement positions 93b together with substrate image 90M.

Fig. 7 illustrates that the measurement result of the height of substrate 90 at reference measurement position 93a of X-axis coordinate X10 and Y-axis coordinate Y10 is height H10. In addition, Fig. 7 illustrates that the measurement result of the height of substrate 90 at related measurement position 93b of X-axis coordinate X1 and Y-axis coordinate Y1 is height H11. What has been described above for the related measurement position 93b is the same for the remaining seven related measurement positions 93b.

Display section 74 may further display a height difference obtained by subtracting the minimum value from the maximum value of the measurement result of reference measurement position 93a and related measurement position 93b measured by measurement section 73. As a result, the operator can easily recognize the height difference, and can grasp the situation around reference measurement position 93a based on the height difference. Fig. 7 illustrates that the height difference with respect to the measurement results of reference measurement position 93a and eight related measurement positions 93b is height difference DF10.

It should be noted that in the manufacturing of substrate product 900, when the height of substrate 90 is measured by measurement device 60 with respect to both reference measurement position 93a and related measurement position 93b, a measurement time may increase, and a measurement operation may also be complicated. Therefore, measurement section 73 may allow measurement device 60 to measure the height of substrate 90 for both reference measurement position 93a and related measurement position 93b in the trial manufacturing or the initial product confirmation of substrate product 900.

In addition, in the manufacturing of substrate product 900, measurement section 73 may allow measurement of the height of substrate 90 at reference measurement position 93a, and restrict the measurement of the height of substrate 90 at related measurement position 93b. As described above, in the trial manufacturing or the initial product confirmation of substrate product 900 and the manufacturing of substrate product 900, the number of measurements for measuring the height of substrate 90 can be changed for the same type of substrate 90.

As described above, substrate 90 may be provided with multiple measurement planned positions 91. Setting section 72 can set, for each of multiple measurement planned positions 91, related measurement position 93b which is at least one measurement position 93 around reference measurement position 93a that is measurement position 93 adjusted and set with respect to measurement planned position 91, or measurement position 93 set without being adjusted with respect to measurement planned position 91.

Fig. 8 illustrates a setting example of reference measurement position 93a and related measurement position 93b. Fig. 8 illustrates an example of a state in which reference measurement position 93a and eight related measurement positions 93b are set for each of nine measurement planned positions 91 illustrated in Fig. 5. Six reference measurement positions 93a of nine reference measurement positions 93a are adjusted and set with respect to measurement planned position 91. Three reference measurement positions 93a of nine reference measurement positions 93a are set without being adjusted with respect to measurement planned position 91.

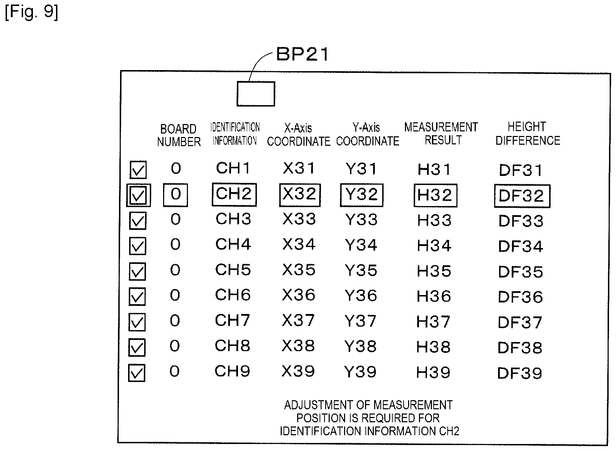

Display section 74 can list the identification information for identifying corresponding measurement planned position 91 for multiple reference measurement positions 93a, the coordinates of reference measurement position 93a on substrate 90, and the measurement results measured by measurement section 73. For example, after the height of substrate 90 is measured by measurement device 60, the operator operates operation section BP12 illustrated in Fig. 7. As a result, display section 74 allows display device 50 to display the information illustrated in Fig. 9 in a list. Fig. 9 illustrates a display example of the measurement result of the height of substrate 90 measured at measurement position 93 in Fig. 8.

In the example illustrated in Fig. 9, a check box, a board number, the identification information of measurement planned position 91, the coordinates (X-axis coordinates and Y-axis coordinates) of reference measurement position 93a, the measurement result measured by measurement section 73, and the height difference are displayed. The check box allows the operator to select the presence or absence of a check using the input device, and displays the measurement result or the like of reference measurement position 93a that is checked.

The board number is identification information for identifying, in one substrate 90, a multi-chamfered substrate on which multiple substrates 90 smaller than substrate 90 are formed so as to be separable, and identification information is assigned to the entire multi-chamfered substrate and each of multiple substrates 90 included in the multi-chamfered substrates. Substrate height measuring device 70 can allow measurement device 60 to measure the height of substrate 90 with respect to the entire multi-chamfered substrate. In addition, substrate height measuring device 70 can allow measurement device 60 to measure the height of substrate 90 for each of multiple substrates 90 included in the multi-chamfered substrate.

Fig. 9 illustrates that reference measurement positions 93a of X-axis coordinate X31 and Y-axis coordinate Y31 are checked by the operator, the board number is the zero number, and the identification information of corresponding measurement planned position 91 is identification information CH1. In addition, it is indicated that the measurement result of the height of substrate 90 at reference measurement position 93a is height H31, and the height difference between reference measurement position 93a and eight related measurement positions 93b set around reference measurement position 93a is height difference DF31. The same applies to remaining eight reference measurement positions 93a.

Display section 74 can also change a display method so as to distinguish between the display of reference measurement position 93a at which the height difference exceeds a predetermined value and the display of reference measurement position 93a at which the height difference is equal to or less than a predetermined value. As a result, the operator can easily grasp reference measurement position 93a at which the height difference exceeds the predetermined value. The predetermined value of the height difference can be inputted by the operator, for example, in the input section BP21 illustrated in Fig. 9. In Fig. 9, the above-mentioned information is surrounded by a rectangle for reference measurement position 93a of X-axis coordinate X32 and Y-axis coordinate Y32, indicating that height difference DF32 exceeds the predetermined value.

As long as display section 74 can display distinguishably the display of reference measurement position 93a at which the height difference exceeds the predetermined value and the display of reference measurement position 93a at which the height difference is equal to or less than the predetermined value, the display method is not limited. For example, display section 74 can change the display method of display device 50 according to at least one of the difference in display colors, the presence or absence of a marker, and the difference in icons.

For example, display section 74 can display reference measurement position 93a at which the height difference exceeds the predetermined value, using a display color (for example, yellow, red, or the like) that is easy for the operator to pay attention to as compared with the display color for the reference measurement position 93a at which the height difference is equal to or less than the predetermined value. The same applies to the marker and the icon, and may take various forms such as a display color, a form, a movement in a display screen, and a blinking display that can be easily noticed by an operator.

Display section 74 can also guide the adjustment of reference measurement position 93a at which the height difference exceeds a predetermined value with respect to measurement planned position 91. In Fig. 9, it is displayed that the adjustment of measurement position 93 is necessary for identification information CH2. As a result, the operator can easily grasp reference measurement position 93a (in this case, reference measurement position 93a of X-axis coordinate X32 and Y-axis coordinate Y32) at which the height difference exceeds the predetermined value, and can perform the adjustment with respect to measurement planned position 91.

In the above-described embodiment, reference measurement position 93a is adjusted as necessary with respect to measurement planned position 91, so that reference measurement position 93a and related measurement position 93b are set. Then, the height of substrate 90 is measured at set reference measurement position 93a and related measurement position 93b, and reference measurement position 93a is readjusted as necessary for reference measurement position 93a at which the height difference exceeds the predetermined value.

However, substrate height measuring device 70 can also set reference measurement position 93a at the same position as measurement planned position 91, and set related measurement position 93b based on reference measurement position 93a. In this case, substrate height measuring device 70 allows measurement device 60 to measure the height of substrate 90 at reference measurement position 93a and related measurement position 93b that are set at the same position as measurement planned position 91. Then, substrate height measuring device 70 can image substrate 90, reset reference measurement position 93a and related measurement position 93b, re-measure the height of substrate 90, and the like with respect to reference measurement position 93a at which the height difference exceeds the predetermined value.

### 2. Substrate height measuring method

The above description of substrate height measuring device 70 can be similarly applied to a substrate height measuring method. Specifically, the substrate height measuring method includes an imaging step, a setting steps, and a measurement step. The imaging step corresponds to control performed by imaging section 71. The setting step corresponds to control performed by setting section 72. The measurement step corresponds to control performed by measurement section 73. In addition, the substrate height measuring method may include a display step. The display step corresponds to control performed by display section 74.

### 3. Example of effects of embodiment

According to substrate height measuring device 70, imaging section 71, setting section 72, and measurement section 73 are provided. Accordingly, substrate height measuring device 70 can allow measurement device 60 to measure the height of substrate 90 by enabling measurement device 60 to adjust measurement position 93 at which the height of substrate 90 is actually measured based on measurement planned position 91 of substrate image 90M displayed on display device 50. The above description of substrate height measuring device 70 can be similarly applied to the substrate height measuring method.

### Reference Signs List

40: imaging device, 50: display device, 60: measurement device, 70: substrate height measuring device, 71: imaging section, 72: setting section, 73: measurement section, 74: display section, 90: substrate, 91: measurement planned position, 92: region, 93: measurement position, 93a: reference measurement position, 93b: related measurement position, 94: indicating member, 90M: substrate image, FP0: specific position, P0: component, 900: substrate product

## Claims

1. A substrate height measuring device (70) comprising:
a setting section (72) configured to adjust a measurement position (93) at which a height of a substrate is measured; and
a measurement section (73) configured to allow a measurement device (60) to measure the height of the substrate (90) at the measurement position (93) set by the setting section (72),
an imaging section (71) configured to allow an imaging device (40) to image a region (92) of at least a part of a clamped substrate (90), the region including a measurement planned position (91) at which the height of the substrate (90) is to be measured, **characterized in that** the measurement planned position (91) is being set in advance in accordance with a substrate type; wherein the setting section (72) is configured to allow a display device (50) to display a substrate image imaged by the imaging section (71) and adjust the measurement position (93) at which the height of the substrate (90) is actually measured based on the measurement planned position (91) of the substrate image displayed on the display device (60) to set the measurement position (93),
wherein the setting section (72) is configured to set a specific position of the substrate image indicated by an operator as the measurement position (93).

2. The substrate height measuring device (70) according to Claim 1,
wherein the setting section (72) is configured to allow an indicating member (94) to be displayed in a predetermined region including the measurement planned position (91) of the substrate image displayed on the display device (50), and the operator to move the indicating member (94) using an input device to allow the operator to indicate the specific position.

3. The substrate height measuring device (70) according Claim 1 or 2,
wherein the setting section (72) is configured to set a related measurement position (93b) which is at least one measurement position around a reference measurement position (93a) that is the measurement position (93) adjusted and set with respect to the measurement planned position (91), or the measurement position (93) set without being adjusted with respect to the measurement planned position (91).

4. The substrate height measuring device (70) according to Claim 3,
wherein the reference measurement position (93a) and the related measurement position (93b) are disposed on lattice points.

5. The substrate height measuring device (70) according to any one of Claims 1 to 4,
wherein the measurement section (73) is configured to measure the height of the substrate (90) in trial manufacturing of a substrate product (900) in which a component (P0) is mounted on the substrate (90) performed before manufacturing the substrate product (900) or in initial product confirmation when a type of the substrate product (900) to be manufactured is switched.

6. The substrate height measuring device (70) according to any one of Claims 1 to 5, further comprising:
a display section (74) configured to display coordinates of the measurement position on the substrate and measurement results measured by the measurement section on the display device.

7. The substrate height measuring device (70) according to Claim 6,
wherein multiple measurement planned positions (91) are provided on the substrate (90),
the setting section (72) is configured to set, for each of the multiple measurement planned positions (91), a related measurement position (93b) which is at least one measurement position around a reference measurement position (93a) that is the measurement position (93) adjusted and set with respect to the measurement planned position (91), or the measurement position (93) set without being adjusted with respect to the measurement planned position (91), and
the display section (74) is configured to list identification information for identifying corresponding measurement planned positions (91) for multiple reference measurement positions (93a), coordinates of the reference measurement position (93a) on the substrate (90), and a measurement result measured by the measurement section (73).

8. The substrate height measuring device (70) according to Claim 6 or 7,
wherein the setting section (72) is configured to set a related measurement position (93b) which is at least one measurement position around a reference measurement position (93a) that is the measurement position (93) adjusted and set with respect to the measurement planned position (91), or the measurement position (93) set without being adjusted with respect to the measurement planned position (91), and
the display section (74) is configured to further display a height difference obtained by subtracting a minimum value from a maximum value of measurement results of the reference measurement position (93a) and the related measurement position (93b) measured by the measurement section.

9. The substrate height measuring device (70) according to Claim 8,
wherein the display section (74) is configured to change a display method so as to distinguish between display of the reference measurement position (93a) at which the height difference exceeds a predetermined value and display of the reference measurement position (93a) at which the height difference is equal to or less than the predetermined value.

10. The substrate height measuring device (79) according to Claim 8 or 9,
wherein the display section (74) is configured to guide adjustment of the reference measurement position (93a) at which the height difference exceeds a predetermined value with respect to the measurement planned position (91).

11. A substrate height measuring method comprising:
a setting step (S12) of adjusting a measurement position at which a height of a substrate is measured; and
a measurement step (S13) of allowing a measurement device to measure the height of the substrate (90) at the measurement position (93) set by the setting step,
an imaging step (S11) of allowing an imaging device to image a region (92) of at least a part of a clamped substrate (90), the region (92) including a measurement planned position (91) at which the height of the substrate (90) is to be measured, **characterized in that** the measurement planned position (91) is being set in advance in accordance with a substrate type wherein the setting step (S12) includes allowing a display device to display a substrate image imaged in the imaging step and adjusting the measurement position (93) at which the height of the substrate (90) is actually measured based on the measurement planned position (91) of the substrate image displayed on the display device to set the measurement position (93), and
the setting step (S12) includes setting a specific position of the substrate image indicated by an operator as the measurement position (93).

## Patentansprüche

1. Eine Substrathöhen-Messvorrichtung (70), aufweisend:
einen Einstellabschnitt (72), der so konfiguriert ist, dass er eine Messposition (93) einstellt, an der eine Höhe eines Substrats gemessen wird; und
einen Messabschnitt (73), der so konfiguriert ist, dass er es einer Messvorrichtung (60) ermöglicht, die Höhe des Substrats (90) an der durch den Einstellabschnitt (72) eingestellten Messposition (93) zu messen,
einen Abbildungsabschnitt (71), der so konfiguriert ist, dass er es einer Abbildungsvorrichtung (40) ermöglicht, einen Bereich (92) von mindestens einem Teil eines eingespannten Substrats (90) abzubilden, wobei der Bereich eine geplante Messposition (91) enthält, an der die Höhe des Substrats (90) zu messen ist,
**dadurch gekennzeichnet, dass** die geplante Messposition (91) im Voraus in Übereinstimmung mit einem Substrattyp eingestellt wird; wobei
der Einstellabschnitt (72) so konfiguriert ist, dass er es einer Anzeigevorrichtung (50) ermöglicht, ein von dem Abbildungsabschnitt (71) abgebildetes Substratbild anzuzeigen und die Messposition (93), an der die Höhe des Substrats (90) tatsächlich gemessen wird, auf der Grundlage der geplanten Messposition (91) des auf der Anzeigevorrichtung (60) angezeigten Substratbildes einzustellen, um die Messposition (93) festzulegen,
wobei der Einstellabschnitt (72) so konfiguriert ist, dass er eine spezifische Position des Substratbildes, die von einem Bediener angegeben wird, als die Messposition (93) einstellt.

2. Die Substrathöhen-Messvorrichtung (70) nach Anspruch 1,
wobei der Einstellabschnitt (72) so konfiguriert ist, dass er die Anzeige eines Anzeigeelements (94) in einem vorbestimmten Bereich ermöglicht, der die für die geplante Messposition (91) des auf der Anzeigevorrichtung (50) angezeigten Substratbildes einschließt, und dass die Bedienungsperson das Anzeigeelement (94) unter Verwendung einer Eingabevorrichtung bewegen kann, um der Bedienungsperson die Anzeige der spezifischen Position zu ermöglichen.

3. Die Substrathöhen-Messvorrichtung (70) nach Anspruch 1 oder 2,
wobei der Einstellabschnitt (72) so konfiguriert ist, dass er eine zugehörige Messposition (93b) einstellt, die mindestens eine Messposition um eine Referenzmessposition (93a) herum ist, bei der es sich um die Messposition (93) handelt, die in Bezug auf die geplante Messposition (91) eingestellt und eingestellt ist, oder um die Messposition (93), die in Bezug auf die geplante Messposition (91) eingestellt ist, ohne eingestellt zu sein.

4. Die Substrathöhen-Messvorrichtung (70) nach Anspruch 3,
wobei die Referenzmessposition (93a) und die zugehörige Messposition (93b) auf Gitterpunkten angeordnet sind.

5. Die Substrathöhen-Messvorrichtung (70) nach einem der Ansprüche 1 bis 4,
wobei der Messabschnitt (73) so konfiguriert ist, dass er die Höhe des Substrats (90) bei der vor der Herstellung des Substratprodukts (900) durchgeführten Testherstellung eines Substratprodukts (900), bei dem ein Bauteil (P0) auf dem Substrat (90) montiert ist, oder bei der anfänglichen Produktbestätigung misst, wenn ein Typ des herzustellenden Substratprodukts (900) gewechselt wird.

6. Die Substrathöhen-Messvorrichtung (70) nach einem der Ansprüche 1 bis 5, ferner umfassend:
einen Anzeigeabschnitt (74), der so konfiguriert ist, dass er die Koordinaten der Messposition auf dem Substrat und die von dem Messabschnitt gemessenen Messergebnisse auf der Anzeigevorrichtung anzeigt.

7. Die Substrathöhen-Messvorrichtung (70) nach Anspruch 6,
wobei mehrere geplante Messpositionen (91) auf dem Substrat (90) vorgesehen sind,
der Einstellabschnitt (72) konfiguriert ist, um für jede der mehreren geplanten Messpositionen (91) eine zugehörige Messposition (93b) einzustellen, die mindestens eine Messposition um eine Referenzmessposition (93a) herum ist, die die in Bezug auf die geplante Messposition (91) eingestellte und eingestellte Messposition (93) ist, oder die in Bezug auf die geplante Messposition (91) nicht eingestellte Messposition (93) ist, und
der Anzeigeabschnitt (74) so konfiguriert ist, dass er Identifikationsinformationen zum Identifizieren entsprechender geplanter Messpositionen (91) für mehrere Referenzmesspositionen (93a), Koordinaten der Referenzmessposition (93a) auf dem Substrat (90) und ein von dem Messabschnitt (73) gemessenes Messergebnis auflistet.

8. Die Substrathöhen-Messvorrichtung (70) nach Anspruch 6 oder 7,
wobei der Einstellabschnitt (72) so konfiguriert ist, dass er eine zugehörige Messposition (93b) einstellt, die mindestens eine Messposition um eine Referenzmessposition (93a) herum ist, die die in Bezug auf die geplante Messposition (91) eingestellte und eingestellte Messposition (93) ist, oder die in Bezug auf die geplante Messposition (91) nicht eingestellte Messposition (93) ist, und
der Anzeigeabschnitt (74) so konfiguriert ist, dass er ferner eine Höhendifferenz anzeigt, die durch Subtraktion eines Minimalwerts von einem Maximalwert von Messergebnissen der Referenzmessposition (93a) und der zugehörigen Messposition (93b), die von dem Messabschnitt gemessen werden, erhalten wird.

9. Die Substrathöhen-Messvorrichtung (70) nach Anspruch 8,
wobei der Anzeigeabschnitt (74) so konfiguriert ist, dass er ein Anzeigeverfahren ändert, um zwischen der Anzeige der Referenzmessposition (93a), bei der die Höhendifferenz einen vorbestimmten Wert überschreitet, und der Anzeige der Referenzmessposition (93a), bei der die Höhendifferenz gleich oder kleiner als der vorbestimmte Wert ist, zu unterscheiden.

10. Die Substrathöhen-Messvorrichtung (79) nach Anspruch 8 oder 9,
wobei der Anzeigeabschnitt (74) so konfiguriert ist, dass er die Einstellung der Referenzmessposition (93a), bei der die Höhendifferenz einen vorbestimmten Wert überschreitet, in Bezug auf die geplante Messposition (91) anleitet.

11. Ein Verfahren zur Messung der Substrathöhe, aufweisend:
einen Einstellschritt (S12) zum Einstellen einer Messposition, an der eine Höhe eines Substrats gemessen wird; und
einen Messschritt (S13), der es einer Messvorrichtung ermöglicht, die Höhe des Substrats (90) an der durch den Einstellschritt eingestellten Messposition (93) zu messen,
einen Abbildungsschritt (S11), der es einer Abbildungsvorrichtung ermöglicht, einen Bereich (92) von mindestens einem Teil eines eingespannten Substrats (90) abzubilden, wobei der Bereich (92) eine geplante Messposition (91) enthält, an der die Höhe des Substrats (90) zu messen ist, **dadurch gekennzeichnet, dass** die geplante Messposition (91) im Voraus in Übereinstimmung mit einem Substrattyp eingestellt wird;
wobei der Einstellschritt (S12) das Zulassen, dass eine Anzeigevorrichtung ein in dem Abbildungsschritt abgebildetes Substratbild anzeigt, und das Einstellen der Messposition (93), an der die Höhe des Substrats (90) tatsächlich gemessen wird, auf der Grundlage der geplanten Messposition (91) des auf der Anzeigevorrichtung angezeigten Substratbildes umfasst, um die Messposition (93) einzustellen, und
der Einstellschritt (S12) das Einstellen einer spezifischen Position des Substratbildes, die von einem Bediener als die Messposition (93) angezeigt wird, umfasst.

## Revendications

1. Dispositif de mesure de hauteur de substrat (70) comprenant :
une section de réglage (72) configurée pour ajuster une position de mesure (93) sur laquelle une hauteur d'un substrat est mesurée ; et
une section de mesure (73) configurée pour permettre à un dispositif de mesure (60) de mesurer la hauteur du substrat (90) sur la position de mesure (93) définie par la section de réglage (72),
une section d'imagerie (71) configurée pour permettre à un dispositif d'imagerie (40) de prendre une image d'une zone (92) d'au moins une partie d'un substrat serré (90), la zone incluant une position de mesure planifiée (91) sur laquelle la hauteur du substrat (90) est à mesurer, **caractérisé en ce que** la position de mesure planifiée (91) est définie à l'avance conformément à un type de substrat ; dans lequel
la section de réglage (72) est configurée pour permettre à un dispositif d'affichage (50) d'afficher une image de substrat prise par la section d'imagerie (71) et d'ajuster la position de mesure (93) sur laquelle la hauteur du substrat (90) est réellement mesurée selon la position de mesure planifiée (91) de l'image de substrat affichée sur le dispositif d'affichage (60) pour définir la position de mesure (93),
dans lequel la section de réglage (72) est configurée pour définir une position spécifique de l'image de substrat indiquée par un opérateur en tant que position de mesure (93).

2. Le dispositif de mesure de hauteur de substrat (70) selon la revendication 1,
dans lequel la section de réglage (72) est configurée pour permettre à un élément d'indication (94) d'être affiché dans une zone prédéterminée incluant la position de mesure planifiée (91) de l'image de substrat affichée sur le dispositif d'affichage (50), et à l'opérateur de déplacer l'élément d'indication (94) en utilisant un dispositif d'entrée pour permettre à l'opérateur d'indiquer la position spécifique.

3. Le dispositif de mesure de hauteur de substrat (70) selon la revendication 1 ou 2,
dans lequel la section de réglage (72) est configurée pour définir une position de mesure associée (93b) qui est au moins une position de mesure autour d'une position de mesure de référence (93a) qui est la position de mesure (93) ajustée et définie par rapport à la position de mesure planifiée (91), ou la position de mesure (93) définie sans être ajustée par rapport à la position de mesure planifiée (91).

4. Le dispositif de mesure de hauteur de substrat (70) selon la revendication 3,
dans lequel la position de mesure de référence (93a) et la position de mesure associée (93b) sont disposées sur des points maillés.

5. le dispositif de mesure de hauteur de substrat (70) selon l'une quelconque des revendications 1 à 4,
dans lequel la section de mesure (73) est configurée pour mesurer la hauteur du substrat (90) dans une fabrication par essai d'un produit de substrat (900) dans laquelle un composant (P0) est monté sur le substrat (90) exécutée avant une fabrication du produit de substrat (900) ou dans une confirmation de produit initial lorsqu'un type de produit de substrat (900) à fabriquer est permuté.

6. le dispositif de mesure de hauteur de substrat (70) selon l'une quelconque des revendications 1 à 5, comprenant en outre :
une section d'affichage (74) configurée pour afficher des coordonnées de la position de mesure sur le substrat et des résultats de mesure mesurés par la section de mesure sur le dispositif d'affichage.

7. Le dispositif de mesure de hauteur de substrat (70) selon la revendication 6,
dans lequel plusieurs positions de mesure planifiées (91) sont disposées sur le substrat (90),
la section de réglage (72) est configurée pour définir, pour chacune des plusieurs positions de mesure planifiées (91), une position de mesure associée (93b) qui est au moins une position de mesure autour d'une position de mesure de référence (93a) qui est la position de mesure (93) ajustée et définie par rapport à la position de mesure planifiée (91), ou la position de mesure (93) définie sans être ajustée par rapport à la position de mesure planifiée (91), et
la section d'affichage (74) est configurée pour répertorier des informations d'identification pour identifier des positions de mesure planifiées correspondantes (91) pour plusieurs positions de mesure de référence (93a), des coordonnées de la position de mesure de référence (93a) sur le substrat (90) et un résultat de mesure mesuré par la section de mesure (73).

8. Le dispositif de mesure de hauteur de substrat (70) selon la revendication 6 ou 7,
dans lequel la section de réglage (72) est configurée pour définir une position de mesure associée (93b) qui est au moins une position de mesure autour d'une position de mesure de référence (93a) qui est la position de mesure (93) ajustée et définie par rapport à la position de mesure planifiée (91), ou la position de mesure (93) définie sans être ajustée par rapport à la position de mesure planifiée (91), et
la section d'affichage (74) est configurée pour afficher en outre une différence de hauteur obtenue en soustrayant une valeur minimale d'une valeur maximale de résultats de mesure de la position de mesure de référence (93a) et de la position de mesure associée (93b) mesurés par la section de mesure.

9. Le dispositif de mesure de hauteur de substrat (70) selon la revendication 8,
dans lequel la section d'affichage (74) est configurée pour changer un procédé d'affichage de sorte à faire une distinction entre un affichage de la position de mesure de référence (93a) sur laquelle la différence de hauteur dépasse une valeur prédéterminée et un affichage de la position de mesure de référence (93a) sur laquelle la différence de hauteur est inférieure ou égale à la valeur prédéterminée.

10. Le dispositif de mesure de hauteur de substrat (79) selon la revendication 8 ou 9,
dans lequel la section d'affichage (74) est configurée pour guider un ajustement de la position de mesure de référence (93a) sur laquelle la différence de hauteur dépasse une valeur prédéterminée par rapport à la position de mesure planifiée (91).

11. Procédé de mesure de hauteur de substrat comprenant :
une étape de réglage (S12) d'ajustement d'une position de mesure sur laquelle une hauteur d'un substrat est mesurée ; et
une étape de mesure (S13) permettant à un dispositif de mesure de mesurer la hauteur du substrat (90) sur la position de mesure (93) définie à l'étape de réglage,
une étape de prise d'image (S11) permettant à un dispositif d'imagerie de prendre une image d'une zone (92) d'au moins une partie d'un substrat serré (90), la zone (92) incluant une position de mesure planifiée (91) sur laquelle la hauteur du substrat (90) est à mesurer, **caractérisé en ce que** la position de mesure planifiée (91) est définie à l'avance conformément à un type de substrat,
dans lequel l'étape de réglage (S12) inclut de permettre à un dispositif d'affichage d'afficher une image de substrat prise à l'étape de prise d'image et d'ajuster la position de mesure (93) sur laquelle la hauteur du substrat (90) est réellement mesurée selon la position de mesure planifiée (91) de l'image de substrat affichée sur le dispositif d'affichage pour définir la position de mesure (93), et
l'étape de réglage (S12) inclut une définition d'une position spécifique de l'image de substrat indiquée par un opérateur en tant que position de mesure (93).
